# EUROPEAN PATENT APPLICATION

(11) **EP 3 890 458 A1**
(43) Date of publication of application: **06.10.2021**
(21) Application number: 19889068.3
(22) Date of filing: 27.11.2019
(51) Int. Cl.: H05K 3/18, H05K 3/24, C25D 1/00, C25D 7/06

(54) **CIRCUIT PATTERN CONTINUOUS MANUFACTURING DEVICE**

(30) Priority: 29.11.2018 KR 20180150906
(71) Applicant: Samwon Act Co., Ltd., Busan 47035 (KR)
(72) Inventor: LEE, Kyung Yul, Bucheon-si Gyeonggi-do 14665 (KR); CHOI, Kwang Jong, Ansan-si Gyeonggi-do 15541 (KR); SONG, Heung Hyeon, Bucheon-si Gyeonggi-do 14645 (KR); CHOI, Eun Yoo, Suwon-si Gyeonggi-do 16295 (KR)
(74) Representative: SR Huebner - Munich Patent-und RechtsanwaltsPartG mbB
(86) International application number: PCT/KR2019/016410
(87) International publication number: WO 2020/111751

(57) **Abstract**

Disclosed is a circuit pattern continuous manufacturing device capable of quickly manufacturing a circuit pattern having a sufficient thickness. The circuit pattern continuous manufacturing device may include: an unwinder configured to unwind a transfer film to be horizontally unfolded; a rotary drum-type continuous electroforming part configured to form a circuit pattern having a first metal layer on the surface of a rotating cathode drum through electroforming; a continuous transfer part configured to transfer the circuit pattern, formed on the surface of the cathode drum of the rotary drum-type continuous electroforming part, onto the transfer film; a first horizontal plating path configured to additionally plate the circuit pattern, transferred onto the transfer film, with a second metal layer made of the same metal as the rotary drum-type continuous electroforming part; and a rewinder configured to rewind the transfer film.

## Description

### Technical Field

The present disclosure relates to a circuit pattern continuous manufacturing device using a roll-to-roll process and a rotary drum-type continuous electroforming process. More specifically, the present disclosure relates to a circuit pattern continuous manufacturing device capable of quickly manufacturing a circuit pattern having a sufficient thickness.

### Background Art

In general, a roll-to-roll continuous manufacturing device refers to a device that performs various types of processes on a roll-type film or web (hereafter, collectively referred to as a film). Such a roll-to-roll continuous manufacturing device includes an unwinder for unwinding a film wound in a roll shape. Furthermore, the roll-to-roll continuous manufacturing device includes processing units for performing various processes, such as a printing process, on the film. Furthermore, the roll-to-roll continuous manufacturing process may include a rewinder for rewinding the film in a roll shape and various transport units for transporting the film between the unwinder and the rewinder.

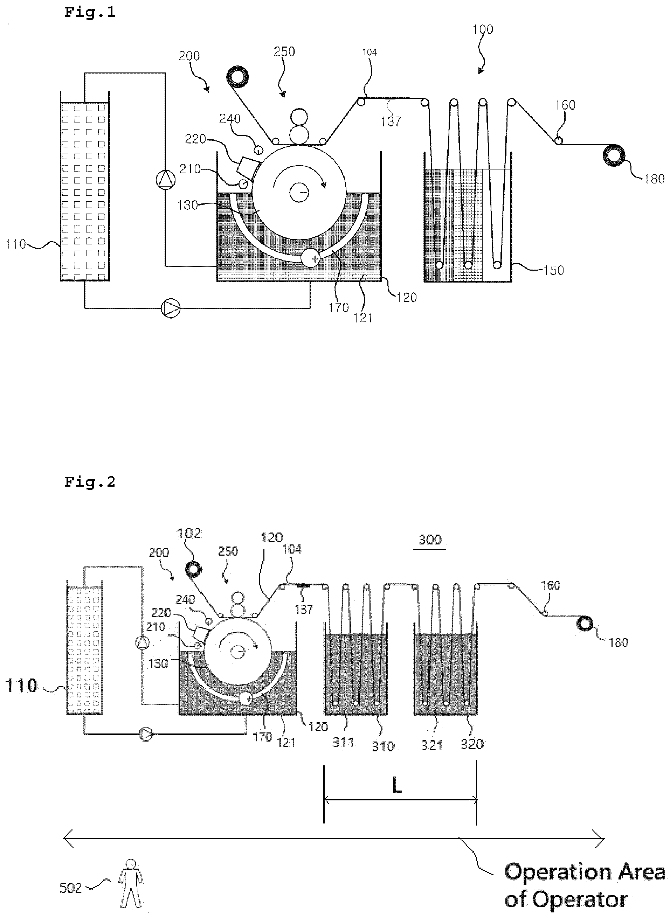

FIG. 1 illustrates a conventional circuit pattern continuous manufacturing device.

The device illustrated in FIG. 1 uses a roll-to-roll continuous manufacturing device and a rotary drum-type continuous electroforming device.

The circuit pattern roll-to-roll continuous manufacturing device illustrated in FIG. 1 includes an unwinder 102 disposed at the front end of a rotary drum-type continuous electroforming part 200 and configured to unwind a transfer film, wound in a roll shape, to be unfolded in a horizontal direction. A circuit pattern 137 formed on the surface of a cathode drum 130 of the rotary drum-type continuous electroforming part 200 is continuously transferred onto a transfer film 104 which is unfolded in the horizontal direction and moved. Finally, a rewinder 180 disposed at the rear of the continuous electroforming part 200 rewinds the transfer film 104, onto which the circuit pattern 137 has been transferred, in a roll shape.

The rotary drum-type continuous electroforming part 200 forms a circuit pattern having a metal layer made of a first metal. The first metal may be copper. The rotary drum-type continuous electroforming part 200 includes an auxiliary tank 110, a plating bath 120, the cathode drum 130 and an anode basket 170.

The plating bath 120 is a bath for containing plating liquid 121 with which the surface of the cathode drum 130 is to be plated. When the circuit pattern 137 is continuously manufactured, only the plating liquid contained in the plating bath 120 may not be enough to manufacture the circuit pattern 137. Thus, the separate auxiliary tank 110 is connected to the plating bath 120 in order to circulate the plating liquid 121.

The cathode drum 130 is connected to a negative terminal (-) of applied power, and rotatably installed in the plating bath 120.

The cathode drum 130 has an engraved portion (not illustrated) formed on the surface thereof, the engraved portion having a negative shape corresponding to the shape of the circuit pattern 137 which is to be manufactured. The other portion of the cathode drum 135, except the engraved portion, is coated with an insulator. The engraved portion may be formed of a single metal or alloy according to the component of plating liquid to be applied, and integrated with the cathode drum 130 by directly processing the surface of the cathode drum 130.

Since the engraved portion formed at the surface of the cathode drum 130 is made of a conductor and the other portion of the cathode drum 130 is made of an insulator, plating is performed only on the engraved portion.

Reference numerals 210, 220 and 240, which are not described, represent a plating liquid removing part, a cleaning part and a cleaning fluid drying part.

A continuous transfer part 250 is installed over the outer circumferential surface of the cathode drum 130. As the cathode drum 130 is rotated in the plating bath 120, the continuous transfer part 250 transfers the circuit pattern 137, with which the engraved portion (not illustrated) has been plated, onto the transfer film 104.

The circuit pattern 137 transferred onto the transfer film 104 is cleaned and dried through a cleaning part 150 and a drying part 160. Finally, the transfer film 104 is wound by the rewinder 180.

The anode basket 170 is formed in a semicircular arc shape, in order to house the cathode drum 130 therein. The anode basket 170 is completely immersed in the plating liquid 121, connected to a positive terminal (+) of the applied power, and spaced by a predetermined interval apart from the cathode drum 130 such that the surface of the cathode drum 130 is plated with the plating liquid 121.

A metal cluster having the same component as the plating liquid 121 is contained in the anode basket 170, and positive (+) ions obtained by dissolving the metal cluster are moved to the engraved portion formed at the surface of the cathode drum 130, and precipitated to electroform the circuit pattern 137 on the surface of the cathode drum 130.

The conventional circuit pattern continuous manufacturing device 100 illustrated in FIG. 1 can continuously manufacture the circuit pattern 137 through continuous electroforming and continuous transfer.

However, the conventional circuit pattern continuous manufacturing device 100 may require a long manufacturing time when the circuit pattern has a large thickness.

In the conventional circuit pattern continuous manufacturing device 100 illustrated in FIG. 1, the thickness of the circuit pattern 137 is decided by the period during which the engraved portion formed on the surface of the cathode drum 130 is immersed in the plating liquid 121, i.e. the rotation speed of the cathode drum 130.

That is, in order to increase the thickness of the circuit pattern, the time in which the cathode drum 130 is immersed in the plating liquid 121 need to be lengthened.

Only when the speed at which the transfer film is moved by the unwinder and the rewinder is synchronized with the rotation speed of the cathode drum 130, the circuit pattern may be transferred at regular intervals.

As the thickness of the circuit pattern 137 is increased, the rotation speed of the cathode drum 130 needs to be slowed down. Thus, the speed at which the transfer film is moved also needs to be slowed down so as to be synchronized with the rotation speed of the cathode drum 130.

Thus, the larger the thickness of the circuit pattern, the longer the manufacturing time for the circuit pattern.

On the other hand, the conventional circuit pattern continuous manufacturing device 100 can provide a circuit pattern made of only one type of metal through the rotary drum-type continuous electroforming part 200, but cannot provide a circuit pattern constituted by various types of metal layers, i.e. a circuit pattern made of an alloy.

Since the circuit pattern made of an alloy can implement various mechanical characteristics according to alloyed metals, the circuit pattern is very useful. However, the conventional circuit pattern continuous manufacturing device cannot implement such a circuit pattern.

For example, it is impossible to control the flexibility, stiffness and corrosion resistance of the circuit pattern.

### DISCLOSURE

### Technical Problem

Various embodiments are directed to a circuit pattern continuous manufacturing device which can quickly manufacture a circuit pattern having a sufficient thickness, using a roll-to-roll process and a rotary drum-type continuous electroforming process.

Also, various embodiments are directed to a circuit pattern continuous manufacturing device which can adjust mechanical characteristics of a circuit pattern.

Further, various embodiments are directed to a circuit pattern continuous manufacturing device which can reduce the length of a manufacturing line, thereby raising space use efficiency.

### Technical Solution

In a first embodiment, there is provided a circuit pattern continuous manufacturing device to which a roll-to-roll process and a continuous electroforming process are applied. The circuit pattern continuous manufacturing device may include: an unwinder configured to unwind a transfer film to be horizontally unfolded; a rotary drum-type continuous electroforming part configured to form a circuit pattern having a first metal layer on the surface of a rotating cathode drum through electroforming; a continuous transfer part configured to transfer the circuit pattern, formed on the surface of the cathode drum of the rotary drum-type continuous electroforming part, onto the transfer film; a first horizontal plating path configured to additionally plate the circuit pattern, transferred onto the transfer film, with a second metal layer made of the same metal as the rotary drum-type continuous electroforming part; and a rewinder configured to rewind the transfer film.

The circuit pattern continuous manufacturing device may further include a second horizontal plating bath disposed between the first horizontal plating bath and the rewinder, and configured to plate the second metal layer with a third metal layer made of a different type of metal from the rotary drum-type continuous electroforming part.

In a second embodiment, there is provided a circuit pattern continuous manufacturing device to which a roll-to-roll process and a continuous electroforming process are applied. The circuit pattern continuous manufacturing device may include: an unwinder configured to unwind a transfer film to be horizontally unfolded; a rotary drum-type continuous electroforming part configured to form a circuit pattern, constituted by a first metal layer, on the surface of a rotating cathode drum through electroforming; a continuous transfer part configured to transfer the circuit pattern, formed on the surface of the cathode drum of the rotary drum-type continuous electroforming part, onto the transfer film; a first turn bar configured to turn the horizontally unfolded transfer film to be vertically erected; a first vertical plating bath configured to plate the circuit pattern, transferred onto the transfer film which is vertically erected and moved, with a second metal layer formed of the same metal as the rotary drum-type continuous electroforming part; and a rewinder configured to rewind the transfer film.

The circuit pattern continuous manufacturing device may further include a second turn bar disposed at the front end of the rewinder, and configured to turn the transfer film, vertically erected through the first vertical plating bath, to be horizontally unfolded.

The circuit pattern continuous manufacturing device may further include a second vertical plating bath disposed between the first vertical plating bath and the rewinder, and configured to plate the second metal layer with a third metal layer made of a different type of metal from the rotary drum-type continuous electroforming part.

The circuit pattern continuous manufacturing device may further include a second turn bar disposed at the front end of the rewinder, and configured to turn the transfer film, vertically erected through the second vertical plating bath, into being horizontally unfolded.

The rotary drum-type continuous electroforming part, the first turn bar, the first vertical plating bath, the second vertical plating bath and the second turn bar may be disposed to form a U-shaped structure.

### Advantageous Effects

In accordance with the present disclosure, the circuit pattern continuous manufacturing device can primarily performing additional plating on the circuit pattern formed by the rotary drum-type continuous electroforming part, thereby quickly manufacturing the circuit pattern having a target thickness.

Furthermore, the circuit pattern continuous manufacturing device can additionally form different types of metal layers on the circuit pattern formed by the rotary drum-type continuous electroforming part, thereby forming the circuit pattern whose mechanical characteristics are adjusted.

Furthermore, the circuit pattern continuous manufacturing device can reduce the length of a manufacturing line through the turn bars and the vertical plating baths, thereby increasing productivity.

### Brief Description of Drawings

FIG. 1 illustrates a configuration of a conventional circuit pattern continuous manufacturing device.
FIG. 2 illustrates a first embodiment of a circuit pattern continuous manufacturing device in accordance with the present disclosure.
FIG. 3 illustrates a second embodiment of the circuit pattern continuous manufacturing device in accordance with the present disclosure.
FIG. 4 illustrates a configuration example of a turn bar illustrated in FIG. 3.
FIG. 5 illustrates an example of a vertical plating bath.
FIG. 6 illustrates a third embodiment of the circuit pattern continuous manufacturing device in accordance with the present disclosure.

### Mode for Invention

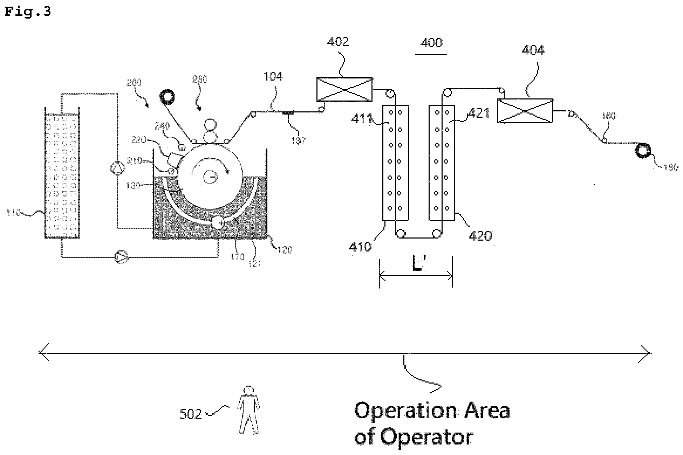

FIG. 3 illustrates a second embodiment of a circuit pattern continuous manufacturing device in accordance with the present disclosure.

In FIG. 3, the same components as those illustrated in FIG. 1 will be represented by like reference numerals, and the detailed descriptions thereof will be omitted herein.

A circuit pattern continuous manufacturing device 400 illustrated in FIG. 3 is characterized in that a first turn bar 402, first and second vertical plating baths 410 and 420 and a second turn bar 404 are installed next to a rotary drum-type continuous electroforming part 200 and a continuous transfer part 250.

The turn bars 402 and 404 serve to change the direction in which a transfer film is unfolded, from a horizontal direction to a vertical direction and from the vertical direction to the horizontal direction, respectively.

Specifically, the first turn bar 402 is installed next to the rotary drum-type continuous electroforming part 200, and serves to turn a transfer film 104 which is horizontally unfolded and moved, such that the transfer film 104 is vertically erected and moved.

The second turn bar 404 serves to turn the transfer film 104 which is vertically erected and moved, such that the transfer film 104 can be horizontally unfold and wound by a rewinder 180.

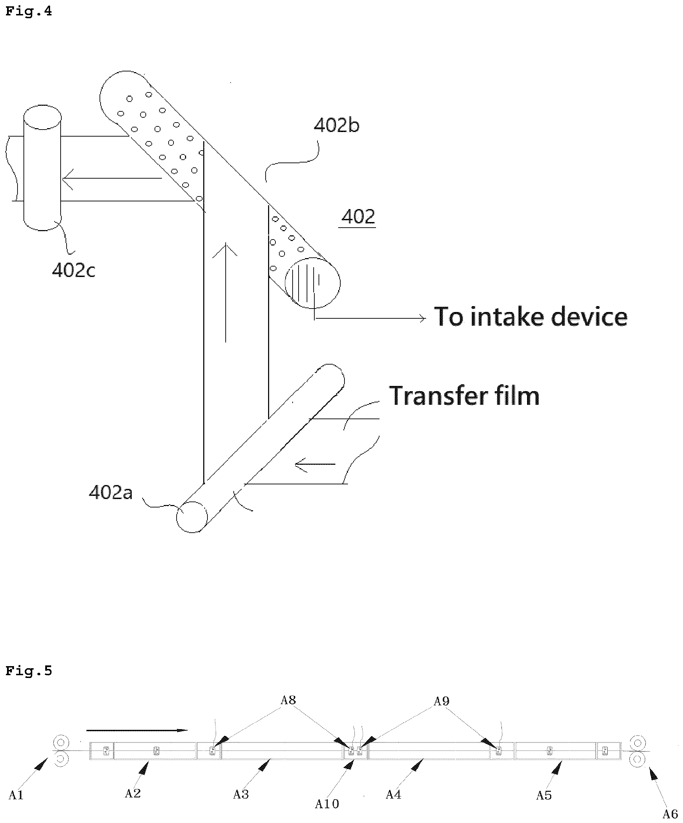

FIG. 4 illustrates a configuration example of the first turn bar.

Referring to FIG. 4, the first turn bar 402 includes a first guide roll 402a, an inclined roll 402b and a second guide roll 402c. The inclined roll 402b is inclined upward at 45° with respect to the first guide roll 402a. While the transfer film is wound and moved along the surface of the inclined roll 402b, the movement direction and the unfold direction of the transfer film are changed before and after the inclined roll 402b. FIG. 4 illustrates that the state of the transfer film, which is horizontally unfolded and moved, is turned into the state in which the transfer film is vertically unfolded, while the transfer film passes through the inclined roll 402b.

FIG. 5 illustrates an example of a vertical plating bath. The inclined roll 402b has small through-holes formed through the surface thereof, and has a hollow portion therein. The inclined roll 402b has one end connected to an intake valve.

When the outside air is drawn into the inclined roll 402b through the intake valve, the transfer film is moved while slightly sticking to the surface of the inclined roll 402b. Such an intake action prevents the transfer film from moving to the top and bottom of the inclined roll 402b.

The transfer film is moved by a pulling force of an unwinder 102 or the rewinder 180, and the movement direction and the unfold direction of the transfer film are changed by the inclined roll 402b.

The inclination direction of the inclined roll 402b and the arrangement of the guide roll 402a and the inclined roll 402b may be differently combined to constitute various types of turn bars.

Since the second turn bar 404 has a similar configuration to that of the first turn bar 402 except the movement direction of the transfer film, the illustration of the second turn bar 404 is omitted herein.

A circuit pattern 137 having a first metal layer may be acquired through a cathode drum 130, and additionally plated by a first vertical plating bath 410 to increase the thickness of the circuit pattern 137.

At this time, the current density of the first vertical plating bath 410 may be set to a higher value than that of the rotary drum-type continuous electroforming part 200, in order to quickly achieve the target thickness of the circuit pattern.

Then, the circuit pattern 137 may be plated with a different type of metal from the first metal through the second vertical plating bath 420. As a result, the circuit pattern 137 made of an alloy may be manufactured.

The device illustrated in FIG. 3 is operated as follows.

The unwinder 102 is disposed at the front end of the rotary drum-type continuous electroforming part 200, and the circuit pattern 137 formed on the surface of the cathode drum 130 by means of electroforming is transferred onto the transfer film 104, which is horizontally unfolded and moved, through the continuous transfer part 250. The rotary drum-type continuous electroforming part 200 forms a circuit pattern having a metal layer made of a first metal. The first metal may be typical copper.

Then, the first turn bar 402 turns the horizontally unfolded transfer film 104 to be vertically erected. The transfer film 104 is additionally plated while passed through the first vertical plating bath 410.

That is, the metal pattern is formed on the cathode drum, the circuit pattern 137 is transferred onto the transfer film through the continuous transfer part 250, and the thickness of the circuit pattern 137 is reinforced through the first vertical plating bath 410.

The second vertical plating bath 420 is a plating bath for containing plating liquid 421 for plating the circuit pattern 137 with a different type of metal.

That is, the circuit pattern 137 may be plated with a different type of metal (e.g. nickel or tin) from the first metal in the rotary drum-type continuous electroforming part 200, in order to acquire the circuit pattern 137 made of an alloy.

Then, the second turn bar 404 turns the vertically erected transfer film into being horizontally unfolded.

Finally, the transfer film 104 having the circuit pattern 137 transferred thereon is rewound by the rewinder 180 disposed at the rear end of the continuous electroforming part 200.

The first and second vertical plating baths 410 and 420 both have a vertical structure. That is, the first and second vertical plating baths 410 and 420 serve to plate the transfer film 104 while the transfer film 104 is vertically erected and moved.

FIG. 3 illustrates that the device uses only one plating bath 420 to form an alloy. If necessary, however, the device may include a plurality of plating baths for forming an alloy.

Furthermore, the position of the first vertical plating bath 410 for forming a thickness and the position of the second vertical plating bath 420 for forming an alloy may be exchanged.

In the device illustrated in FIG. 3, the transfer film 104 is vertically erected and moved between the first and second turn bars 402 and 404 by means of the operations of the first and second turn bars 402 and 404.

Such a reason is in order to use the vertical plating baths.

Table 1 comparatively shows the advantages and disadvantages of a horizontal plating bath and a vertical plating bath.

**[Table 1]**

| | Horizontal plating bath | Vertical plating bath |
|---|---|---|
| Basic concept | Focused on driving stability | configured to prevent product from touching roll as much as possible |
| Driving stability | Suitable for driving with bottom seated at top at all times. Although distortion to left/right occurs, stability is relatively high. | Deflection occurs due to gravity, and is removed by adjusting tension through load cell. |
| Plating quality | Difficult to maintain composition of chemicals because dip has small depth, and difficult to perform fill plating and high-quality plating. No case where bath is applied to fill plating | Able to plate fine pattern, and suitable for fill plating |
| Anode configuration | Mesh-type used; large amount of additives is used; bubble management required; replacement/coating frequently is required because of short lifetime | Anode + Membrane filer used, small amount of additives is used, suitable for managing chemicals |
| Application target | applied to general/highspeed plating | applied to high-end product |
| Device price | relatively inexpensive (50% to 70%) | |

Referring to Table 1, the horizontal plating bath has advantages in terms of equipment price and driving stability, but has disadvantages in terms of additives, chemical management and the possibility to plate fine patterns, compared to the vertical plating bath. FIGS. 2 and 3 show that, when the plating bath is configured as a horizontal plating bath, the length L of a manufacturing line is significantly increased (L >> L').

That is, in the device in accordance with the present disclosure, the transfer film 104 can be vertically erected by the turn bars 402 and 404, and the vertical plating baths 410 and 420 may be successively disposed at a small interval in a zigzag shape, which makes it possible to reduce the entire length of a manufacturing line.

Therefore, an operation area of an operator 502 may be reduced.

The second turn bar 404 may be excluded from the configuration of the device illustrated in FIG. 3. In this case, the rewinder 180 is not horizontally configured, but vertically configured.

FIG. 5 illustrates an example of a vertical plating bath.

Referring to FIG. 5, a transfer film is carried into the vertical plating bath in a direction A1, and carried out of the vertical plating bath in a direction A6.

The vertical plating bath may include a pre-processing stage A2, a first plating bath A3, a second plating bath A4 and a post-processing stage A5.

Each of the processing stages is isolated by an isolation stage. That is, the vertical plating bath has a section structure in which the first and second plating baths A3 and A4 are isolated by one isolation stage disposed therebetween such that chemicals in the first and second plating baths A3 and A4 do not communicate with each other. The transfer film is electro-plated in the first plating bath A3, and then fed into the second plating bath A4 through the isolation stage and electro-plated in the second plating bath A4.

An arrow at the left top in FIG. 5 indicates the movement direction of the transfer film, and the transfer film is supported by tension rolls before and after the vertical plating path.

After the transfer film is completely plated, the transfer film enters the post-processing stage A5 which is constituted by a plurality of small tanks to perform cleaning and drying processes. A8 and A9 represent rollers to apply power.

### Embodiments for carrying out the present disclosure

Hereafter, exemplary embodiments will be described in more detail with reference to the accompanying drawings. Throughout the drawings, like reference numerals represent the same components.

However, the present disclosure may be embodied in different manners, and it should not be construed that the present disclosure is not limited only to the embodiments. Such embodiments are provided as examples that make the present disclosure thorough and complete, and fully deliver the aspects and features of the present disclosure to those skilled in the art.

In order to promote complete understandings of the aspects and features of the present disclosure, processes, elements and techniques which are not necessary for those skilled in the art may not be described. Unless mentioned otherwise, similar reference numerals represent similar elements throughout the accompanying drawings and the descriptions. Thus, the overlapping descriptions thereof will be omitted herein.

In the drawings, the relative sizes of elements, layers and regions may be exaggerated for clarity.

Hereafter, the configuration and operation of the circuit pattern continuous manufacturing device in accordance with the present disclosure will be described in detail with reference to the accompanying drawings.

FIG. 2 illustrates a first embodiment of the circuit pattern continuous manufacturing device in accordance with the present disclosure.

In FIG. 2, the same components as those illustrated in FIG. 1 will be represented by like reference numerals, and the detailed descriptions thereof will be omitted herein.

As illustrated in FIG. 2, a circuit pattern continuous manufacturing device 300 in accordance with the first embodiment is characterized in that first and second horizontal plating paths 310 and 320 are installed at the rear end of a rotary drum-type continuous electroforming part 200.

The first horizontal plating bath 310 is a bath for containing plating liquid 311 with which a circuit pattern is to be plated, in order to raise the thickness thereof.

The circuit pattern 137 having a first metal layer may be acquired through a cathode drum 130, and additionally plated with a second metal layer made of the same material as the first metal layer by the first horizontal plating bath 310 to raise the thickness of the circuit pattern 137.

Through the first horizontal plating bath 310 in which cap-plating or thickness plating is performed, the circuit pattern 137 with a target plating thickness is manufactured at high speed with relatively high current density.

The second horizontal plating bath 320 is a bath for containing plating liquid 321 to form an alloy for adjusting mechanical characteristics.

The circuit pattern 137 may be plated with a different type of metal from the first metal, i.e. a third metal, through the second horizontal plating bath 320. As a result, the circuit pattern 137 made of an alloy may be manufactured.

A third metal layer (or subsequent additional plating layer) aims to reinforce the property of the circuit pattern. Examples of the property may include flexibility, stiffness, corrosion resistance and the like.

The device illustrated in FIG. 2 is operated as follows.

An unwinder 102 is disposed at the front end of a rotary drum-type continuous electroforming part 200, and the circuit pattern 137 formed on the surface of the cathode drum 130 by means of electroforming is transferred onto a transfer film 104, which is horizontally unfolded and moved, through a continuous transfer part 250.

Then, the transfer film 104 is additionally plated while passed through the first horizontal plating bath 310. That is, the circuit pattern 137 is transferred onto the transfer film 104, and passed through the first horizontal plating bath 310 to raise the thickness of the circuit pattern 137.

At this time, the current density of the first horizontal plating bath 310 may be set to a higher value than that of the rotary drum-type continuous electroforming part 200, in order to quickly achieve the target thickness of the circuit pattern.

Then, an alloy is formed by plating the circuit pattern 137 with a different type of metal (third metal) to reinforce flexibility, stiffness and corrosion resistance, while passing the circuit pattern 137 through the second horizontal plating bath 320.

The third metal with which the circuit pattern 137 is plated through the second horizontal plating bath 320 may be selected according to mechanical characteristics required for the circuit pattern 137.

Finally, the transfer film having the circuit pattern 137 transferred thereon is rewound in a roll shape by a rewinder 180 disposed at the rear end of the continuous electroforming part 200.

Typically, a plating bath includes a cleaning part. Such a cleaning part serves to remove an influence on another plating bath by removing a remaining chemical. Therefore, it should be understood that, although no cleaning part is separately illustrated in the drawings, a cleaning process is performed in a plating bath itself.

FIG. 2 illustrates that the device uses only one plating bath 320 to form an alloy. If necessary, however, the device may include a plurality of plating baths for forming an alloy.

Furthermore, the position of the first horizontal plating bath 310 for forming a thickness and the position of the second horizontal plating bath 320 for forming an alloy may be exchanged.

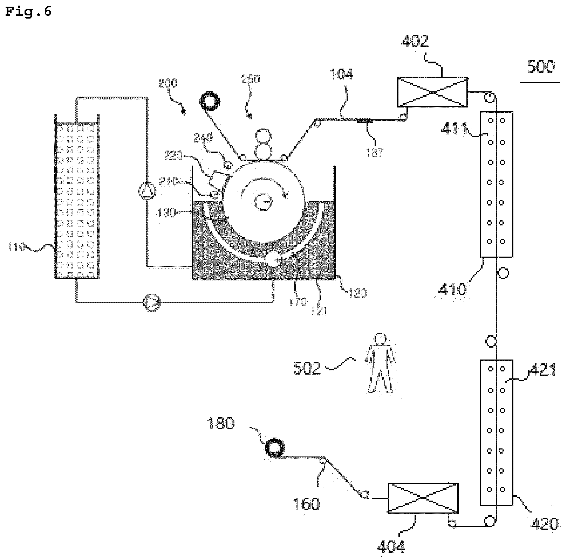

FIG. 6 illustrates a third embodiment of the circuit pattern continuous manufacturing device in accordance with the present disclosure.

The structure illustrated in FIG. 6 is obtained by changing the U-shaped structure of the device illustrated in FIG. 3 into a straight line-shaped structure.

As the straight line-shaped structure illustrated in FIG. 6 is changed to the U-shaped structure illustrated in FIG. 3, an operator's moving line for maintenance may be further reduced. As a result, it is possible to facilitate the movement and the maintenance operation of the operator, and to reduce the number of managing operators.

Considering that the length of each plating bath is about 10m, the operator needs to come and go by about 50m in the case of FIG. 6, but may come and go only by about 20m in the case of FIG. 3, which means that the operation area of the operator is significantly reduced.

### Industrial Applicability

The present disclosure is industrially applicable because the present disclosure provides a circuit pattern continuous manufacturing device capable of rapidly manufacturing a circuit pattern having a sufficient thickness by using a roll-to-roll process and a rotary drum-type continuous electroforming process.

## Claims

1. A circuit pattern continuous manufacturing device to which a roll-to-roll process and a continuous electroforming process are applied, the circuit pattern continuous manufacturing device comprising:
an unwinder configured to unwind a transfer film to be horizontally unfolded;
a rotary drum-type continuous electroforming part configured to form a circuit pattern having a first metal layer on the surface of a rotating cathode drum through electroforming;
a continuous transfer part configured to transfer the circuit pattern, formed on the surface of the cathode drum of the rotary drum-type continuous electroforming part, onto the transfer film;
a first horizontal plating path configured to additionally plate the circuit pattern, transferred onto the transfer film, with a second metal layer made of the same metal as the rotary drum-type continuous electroforming part; and
a rewinder configured to rewind the transfer film.

2. The circuit pattern continuous manufacturing device of claim 1, further comprising a second horizontal plating bath disposed between the first horizontal plating bath and the rewinder, and configured to plate the second metal layer with a third metal layer made of a different type of metal from the rotary drum-type continuous electroforming part.

3. A circuit pattern continuous manufacturing device to which a roll-to-roll process and a continuous electroforming process are applied, the circuit pattern continuous manufacturing device comprising:
an unwinder configured to unwind a transfer film to be horizontally unfolded;
a rotary drum-type continuous electroforming part configured to form a circuit pattern, constituted by a first metal layer, on the surface of a rotating cathode drum through electroforming;
a continuous transfer part configured to transfer the circuit pattern, formed on the surface of the cathode drum of the rotary drum-type continuous electroforming part, onto the transfer film;
a first turn bar configured to turn the horizontally unfolded transfer film to be vertically erected;
a first vertical plating bath configured to plate the circuit pattern, transferred onto the transfer film which is vertically erected and moved, with a second metal layer formed of the same metal as the rotary drum-type continuous electroforming part; and
a rewinder configured to rewind the transfer film.

4. The circuit pattern continuous manufacturing device of claim 3, further comprising a second turn bar disposed at the front end of the rewinder, and configured to turn the transfer film, vertically erected through the first vertical plating bath, to be horizontally unfolded.

5. The circuit pattern continuous manufacturing device of claim 3, further comprising a second vertical plating bath disposed between the first vertical plating bath and the rewinder, and configured to plate the second metal layer with a third metal layer made of a different type of metal from the rotary drum-type continuous electroforming part.

6. The circuit pattern continuous manufacturing device of claim 5, further comprising a second turn bar disposed at the front end of the rewinder, and configured to turn the transfer film, vertically erected through the second vertical plating bath, into being horizontally unfolded.

7. The circuit pattern continuous manufacturing device of claim 6, wherein the rotary drum-type continuous electroforming part, the first turn bar, the first vertical plating bath, the second vertical plating bath and the second turn bar are disposed to form a U-shaped structure.
